(19) Europäisches Patentamt
European Patent Office
Office européen des brevets

(11) **EP 2 945 189 A1**

(12) **EUROPEAN PATENT APPLICATION**
published in accordance with Art. 153(4) EPC

(43) Date of publication:
**18.11.2015 Bulletin 2015/47**

(51) Int Cl.:
**H01L 21/52** *(2006.01)*    **H01L 21/60** *(2006.01)*

(21) Application number: **13870456.4**

(22) Date of filing: **09.01.2013**

(86) International application number:
**PCT/JP2013/050196**

(87) International publication number:
**WO 2014/109014 (17.07.2014 Gazette 2014/29)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Hitachi, Ltd.**
**Chiyoda-ku**
**Tokyo 100-8280 (JP)**

(72) Inventors:
• **TANIE, Hisashi**
  **Hitachi-shi**
  **Ibaraki 319-1292 (JP)**
• **IKEDA, Osamu**
  **Yokohama-shi**
  **Kanagawa 244-0817 (JP)**

(74) Representative: **Beetz & Partner mbB**
**Patentanwälte**
**Steinsdorfstraße 10**
**80538 München (DE)**

(54) **SEMICONDUCTOR DEVICE AND METHOD FOR MANUFACTURING SAME**

(57)    In order to achieve both a reduction in thermal resistance and an improvement in thermal deformation absorbing property of a semiconductor device having a packaging structure in which a semiconductor chip 1 is electrically connected to conductive members 3a and 3b via bonding members 2a and 2b, the bonding members 2a and 2b each includes a stacked structure provided with, in the order from the side close to the semiconductor chip 1, a nanospring layer 4 configured from a plurality of springs having a nano-order size, a planar layer 5 supporting the plurality of springs, and a bonding layer 6. The thickness of the nanospring layer 4 is larger than the thickness of the bonding layer 6, and the thickness of the bonding layer 6 is larger than the thickness of the planar layer 5.

*FIG. 1*

EP 2 945 189 A1

## Description

## TECHNICAL FIELD

The present invention relates to a semiconductor device and a technique for manufacturing the same, and particularly to a technique effectively applied to a reduction in thermal resistance and an improvement in thermal deformation absorbing property in a semiconductor packaging structure incorporating a semiconductor chip.

## BACKGROUND ART

As the background art of the technical field, there are Patent Document 1 (Japanese Patent Application Laid-Open No. 2006-287091), Patent Document 2 (Japanese Patent Application Laid-Open No. 2003-188209), Patent Document 3 (Japanese Patent Application Laid-Open No. 2003-298012), and Non-Patent Document 1.

In Patent Document 1, as a solution to a problem "to prevent the thermal breakage of a semiconductor element due to a high temperature and the occurrence of circuit characteristics and interlayer film cracking due to a high load by adopting a bonding process technique in which connection is carried out at a low temperature under a low load from a thermocompression bonding process in which a high temperature and a high load are applied", a technique is disclosed in which "in a semiconductor device including a semiconductor element 1 with metal bumps 3 formed on a plurality of pad electrode portions 2 and a circuit mounting board 4 including wiring electrode portions 5, conductive elastic bodies 6 having conductivity and elasticity are formed on the wiring electrode portions 5 of the circuit mounting board 4, the semiconductor element 1 is mounted on the circuit mounting board 4 in a state where the metal bumps 3 stick into the conductive elastic bodies 6, and the metal bumps 3 and the wiring electrode portions 5 are electrically connected and fixed by means of an insulating adhesive layer 10" (refer to Abstract).

In Patent Document 2, as a solution to a problem "to provide a semiconductor device and a method for manufacturing the same suitable for suppressing a reduction in connection reliability due to a thermal stress caused by a difference in thermal expansion rate between a semiconductor chip and a circuit board and further realizing high density packaging", a technique is disclosed in which "a minute conductive connecting portion whose shape is controlled is formed by a processed substrate subjected to fine processing and a patterning technique, and the semiconductor chip and the circuit board are connected using the connecting portion. The semiconductor device has a structure in which an electrode pad of the semiconductor chip is connected to an electrode pad of the circuit board via the conductive connecting portion including at least two bent portions or curved portions, and an insulating sealing portion is sealed between the semiconductor chip and the circuit board. In the semiconductor device, when a thermal stress is applied, the conductive connecting portion and the insulating sealing portion are deformed to alleviate the thermal stress, making it possible to improve connection reliability".

In Patent Document 3, as a solution to a problem "to provide a semiconductor device and a method for manufacturing the same in which there are no limitations on heat resistance of element materials to be connected, there is no risk of deterioration of a function of the device or damage to elements due to stress, and there is no risk of occurrence of a short circuit between adjacent electrodes due to contact of adjacent connecting portions", a technique is disclosed in which "a solid imaging element 10 includes a scanning circuit portion 12, a photoelectric converting portion 14, a microspring 16, and a connecting layer 18. The microspring 16 has one end fixed on a pixel electrode 30 by means of a metal or the like, and is formed in a shape of a tongue curved upward. The microspring 16 contacts an electrode 42 on the side of the photoelectric converting portion in a state where the microspring 16 is compressed in an allowable range, and electrically connects the pixel electrode 30 with the electrode 42 on the side of the photoelectric converting portion. The connecting layer 18 structurally connects the scanning circuit portion 12 with the photoelectric converting portion 14".

Non-Patent Document 1 discloses a manufacturing method and dynamic characteristics of a nanospring layer used in the invention.

## RELATED ART DOCUMENTS

## PATENT DOCUMENTS

Patent Document 1: Japanese Patent Application Laid-Open No. 2006-287091
Patent Document 2: Japanese Patent Application Laid-Open No. 2003-188209
Patent Document 3: Japanese Patent Application Laid-Open No. 2003-298012

## NON-PATENT DOCUMENT

Non-Patent Document 1: Takayuki Kitamura et. al, "FRACTURE NANOMECHANICS", PAN STANFORD PUBLISHING (2011), ISBN 978-981-4241-83-0

## SUMMARY OF THE INVENTION

## PROBLEMS TO BE SOLVED BY THE INVENTION

In a packaging structure incorporating a semiconductor chip, since a plurality of different kinds of materials are used in combination with each other, a thermal stress caused by a difference in thermal deformation between members occurs in association with a temperature change. Moreover, when a temperature range to be used is widened in association with diversification of use environments of the semiconductor device, the thermal stress that would occur also increases, therefore, preventing a reduction in the reliability of the semiconductor device due to this thermal stress is a problem. Especially, since the semiconductor chip has a small linear coefficient of expansion compared to that of a peripheral material, a difference in thermal deformation between the semiconductor chip and the peripheral material is increased. Therefore, a deformation absorbing property capable of absorbing the thermal deformation difference is required of a bonding portion between the semiconductor chip and another member such as a conductive material.

Moreover, at the time of operation of the semiconductor device, the semiconductor chip generates heat. Then, when the temperature of the generated heat is increased in association with an increase in packaging density, the temperature rise of the semiconductor chip is remarkable, so that there is a fear of an efficiency reduction of the semiconductor chip due to this temperature rise or damage to the member due to a thermal stress. Thus, in the semiconductor packaging structure, suppressing of the temperature rise, that is, an improvement in heat dissipation property is a problem.

For suppressing the temperature rise of the semiconductor packaging structure, it is desirable that a bonding portion between the semiconductor chip and another member is thinned to reduce a thermal resistance. However, since it is desirable that the bonding portion is made thick for improving the thermal deformation absorbing property of the bonding portion, a reduction in thermal resistance and an improvement in thermal deformation absorbing property are in a trade-off relationship.

An object of the invention is to provide a semiconductor device including a packaging structure capable of achieving both a reduction in thermal resistance and an improvement in thermal deformation absorbing property.

The above and other objects and novel features of the invention will be apparent from the description of the specification and the accompanying drawings.

## MEANS FOR SOLVING THE PROBLEMS

An outline of a typical one of the inventions disclosed in the application will be briefly described below.

An aspect of a semiconductor device according to the present invention has a packaging structure including a semiconductor chip electrically connected to a conductive member via a bonding member, in which the bonding member includes a stacked structure provided with, in the order from the side close to the semiconductor chip, a nanospring layer configured from a plurality of springs having a nano-order size, a planar layer supporting the plurality of springs, and a bonding layer. The thickness of the nanospring layer is larger than the thickness of the bonding layer, and the thickness of the bonding layer is larger than the thickness of the planar layer.

## EFFECTS OF THE INVENTION

Effects obtained by a typical one of the inventions disclosed in the application will be briefly described below.

A nanospring layer is disposed in a portion of a bonding member that bonds a semiconductor chip with a conductive member, so that a difference in thermal deformation between the semiconductor chip and the conductive member can be absorbed by the deformation of the nanospring layer. As a result, it is not necessary to provide the bonding layer with a thermal deformation absorbing property, and the bonding layer can be made thinner than the nanospring layer, therefore, a thermal resistance can be reduced. Moreover, since a planar layer is thinner than the bonding layer, the bending stiffness of the planar layer is reduced, so that the planar layer can follow the deformation of the nanospring layer. Further, since the planar layer is thin, the thermal resistance of the planar layer itself is reduced, so that the planar layer can contribute to a reduction in the thermal resistance of the entire semiconductor device. Due to these, it is possible to realize a semiconductor packaging structure achieving both a high thermal deformation absorbing property and a low thermal resistance.

## BRIEF DESCRIPTIONS OF THE DRAWINGS

FIG. 1(a) is a cross-sectional view of a semiconductor device according to a first embodiment, and FIG. 1(b) is an enlarged cross-sectional view showing a portion of FIG. 1(a).

FIG. 2(a) is an overall perspective view of a semiconductor wafer showing a method for manufacturing the semiconductor device according to the first embodiment, and FIG. 2(b) is an enlarged cross-sectional view showing a portion of FIG. 2(a).

FIG. 3(a) is an overall perspective view of the semiconductor wafer showing the method for manufacturing the semiconductor device continued from FIG. 2(a), and FIG. 3(b) is an enlarged cross-sectional view showing a portion of FIG. 3(a).

FIG. 4(a) is an overall perspective view of the semiconductor wafer showing the method for manufacturing the semiconductor device continued from FIG. 3(a), and FIG. 4(b) is an enlarged cross-sectional view showing a portion of FIG. 4(a).

FIG. 5 (a) is an overall perspective view of the semiconductor wafer showing the method for manufacturing the semiconductor device continued from FIG. 4(a), and FIG. 5(b) is an enlarged cross-sectional view showing a portion of FIG. 5(a).

FIG. 6 (a) is an overall perspective view of the semiconductor wafer showing the method for manufacturing the semiconductor device continued from FIG. 5(a), and FIG. 6(b) is an enlarged cross-sectional view showing a portion of FIG. 6(a).

FIG. 7 is a cross-sectional view of the semiconductor wafer showing the method for manufacturing the semiconductor device continued from FIG. 6.

FIG. 8 is a perspective view of the semiconductor wafer and a semiconductor chip showing the method for manufacturing the semiconductor device continued from FIG. 7.

FIG. 9 is a cross-sectional view showing the method for manufacturing the semiconductor device continued from FIG. 8.

FIG. 10 is a diagram for explaining effects of the semiconductor device according to the first embodiment.

FIG. 11(a) is a cross-sectional view of a semiconductor device according to a second embodiment, and FIG. 11(b) is an enlarged cross-sectional view showing a portion of FIG. 11(a).

FIG. 12 (a) is an overall perspective view of a semiconductor wafer showing a method for manufacturing the semiconductor device according to the second embodiment, and FIG. 12(b) is an enlarged cross-sectional view showing a portion of FIG. 12(a).

FIG. 13 (a) is an overall perspective view of the semiconductor wafer showing the method for manufacturing the semiconductor device continued from FIG. 12(a), and FIG. 13(b) is an enlarged cross-sectional view showing a portion of FIG. 13(a).

FIG. 14(a) is an overall perspective view of the semiconductor wafer showing the method for manufacturing the semiconductor device continued from FIG. 13(a), and FIG. 14(b) is an enlarged cross-sectional view showing a portion of FIG. 14(a).

FIG. 15(a) is a cross-sectional view of a semiconductor device according to a third embodiment, and FIG. 15(b) is an enlarged cross-sectional view showing a portion of FIG. 15(a).

FIG. 16(a) is a cross-sectional view of a semiconductor device according to a fourth embodiment, and FIG. 16(b) is an enlarged cross-sectional view showing a portion of FIG. 16(a).

## DETAILED DESCRIPTION OF PREFERRED EMBODIMENTS

Hereinafter, embodiments of the invention will be described in detail based on the drawings. Throughout the drawings for explaining the embodiments, members having the same function are denoted by the same reference sign and numeral, and the repetitive description thereof is omitted. Moreover, in the embodiments, the description of the same or similar portions is not repeated in principle unless particularly required. Further, in the drawings for explaining the embodiments, hatching may be applied even in a plan view or hatching may be omitted even in a cross-sectional view so as to make configurations easy to see.

(First Embodiment)

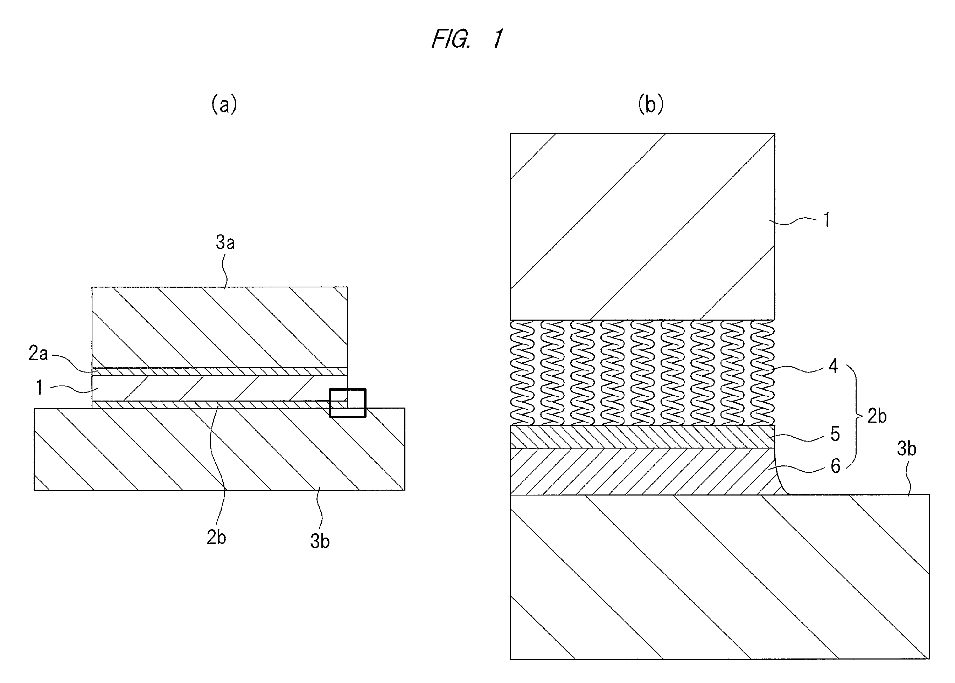

FIG. 1 (a) is a cross-sectional view of a semiconductor device according to a first embodiment of the present invention, and FIG. 1(b) is an enlarged cross-sectional view showing a portion (region surrounded by a rectangular frame) of FIG. 1(a).

As shown in FIG. 1(a), the semiconductor device of the first embodiment has a packaging structure in which an upper surface of a semiconductor chip 1 with a p-n junction formed therein is electrically connected to a conductive member 3a via a bonding member 2a and a lower surface is electrically connected to a conductive member 3b via a bonding member 2b. That is, a current flowing in from one of the pair of conductive members 3a and 3b is rectified by a diode element in the semiconductor chip 1, and flows out from the other of the conductive members 3a and 3b, whereby the semiconductor device functions as a diode.

The semiconductor chip 1 is formed of single-crystal silicon (Si) provided with a diode function in a semiconductor manufacturing process (front-end process), and has dimensions such that each side is about 6 mm and a thickness is about 0.2 mm. Moreover, each of the pair of conductive members 3a and 3b constituting electrodes of the diode is formed of a metal plate such as copper (Cu).

As shown in FIG. 1(b), the bonding member 2b of the pair of bonding members 2a and 2b interposing the semiconductor chip 1 therebetween has a three-layer structure of a nanospring layer 4, a planar layer 5, and a bonding layer 6 in the order from the side close to the semiconductor chip 1. Similarly, although the illustration is omitted, the bonding member 2a also has a three-layer structure of a nanospring layer 4, a planar layer 5, and a bonding layer 6 in the order from the side close to the semiconductor chip 1. An under layer 22 (described later) formed of a nickel film intervenes between the respective nanospring layers 4 of the bonding members 2a and 2b and the semiconductor chip 1, but the film thickness of the under layer 22 is extremely small, therefore, the under layer is not shown in FIG. 1.

The nanospring layer 4 connecting the semiconductor chip 1 with the planar layer 5 has a structure in which a plurality of coil-shaped springs having a nano-order size, that is, a size of equal to or less than 1 $\mu$m are disposed in a matrix. For example, each of the plurality of coil-shaped springs has a substantially circular cross-sectional shape having a diameter of about 25 nm, and has an outside diameter of about 150 nm, an inside diameter of about 100 nm, and a height of about 10 $\mu$m. Moreover, a distance between adjacent springs is about 50 nm, and the material of the spring is nickel (Ni).

In this manner, since the nanospring layer 4 as a portion of each of the bonding members 2a and 2b is configured from a plurality of deformable springs, the bonding members 2a and 2b can efficiently absorb with the nanospring layer 4 a difference in thermal deformation between the semiconductor chip 1 and the conductive members 3a and 3b occurring at the time of operation. As a result, an increase in thermal stress can be prevented, and the cracking of the semiconductor chip 1 or the breakage of the bonding members 2a and 2b due to a thermal stress can be prevented.

A difference in the linear coefficient of expansion between silicon as a main material of the semiconductor chip 1 and copper as a main material of the conductive members 3a and 3b is about 13 ppm/degree. For example, when the temperatures of the semiconductor chip 1 with each side of about 6 mm and of the conductive members 3a and 3b change by 200 degrees, a thermal deformation difference at the edge of the semiconductor chip 1 is about 8 $\mu$m. For absorbing the thermal deformation difference with the deformation of the nanospring layer 4, it is desirable for the nanospring layer 4 to have a thickness of at least 8 $\mu$m or more. In the first embodiment, therefore, the thickness of the nanospring layer 4 is set to 10 $\mu$m.

Moreover, since the semiconductor chip 1 and the planar layer 5 are connected via a plurality of springs configured from nickel (Ni) having high thermal conductivity, a thermal resistance between the semiconductor chip 1 and the planar layer 5 can be reduced, and the heat generated in the semiconductor chip 1 at the time of operation can be efficiently transferred to the conductive members 3a and 3b to reduce the temperature rise of the semiconductor chip 1. Based on these facts, by providing a portion of each of the bonding members 2a and 2b with the nanospring layer 4, it is possible to provide a highly reliable semiconductor device in which a thermal stress or temperature rise is reduced.

The planar layer 5, which is a support member for preventing the plurality of springs of nano-order size that constitute the nanospring layer 4 from coming apart, is configured from, for example, a conductive material such as nickel and has a thickness of about 0.5 $\mu$m. Moreover, by disposing the planar layer 5 adjacent to the nanospring layer 4, a place to be bonded with the bonding layer 6 can be flat. Therefore, the bonding is facilitated, and at the same time, it is possible to prevent the bonding layer 6 from flowing into gaps of the nanospring layer 4 at the time of bonding. Further, when nickel is used for the material of the planar layer 5, the surface of the planar layer 5 is hardly oxidized at a manufacturing stage, therefore, it is possible to prevent a surface oxide layer from being obstructive to manufacture.

The thickness of the planar layer 5 is about 0.5 $\mu$m, which is small compared to the nanospring layer 4. The reason for this is that by providing the planar layer 5 with reduced thickness, the bending stiffness of the planar layer 5 is reduced to improve the bondability when bonding the planar layer 5 and the conductive members 3a and 3b via the bonding layer 6. That is, even when there are irregularities on the surface of the planar layer 5 or the conductive members 3a and 3b before bonding, the irregularities are absorbed by the deformation of the nanospring layer 4, and favorable bonding can be obtained. In this case, since the planar layer 5 is thin and has a small bending stiffness, the planar layer 5 can follow the deformation of the nanospring layer 4. Further, since the planar layer 5 is thin, the thermal resistance of the planar layer 5 itself is reduced, so that the planar layer 5 can contribute to a reduction in the thermal resistance of the entire semiconductor device.

The bonding layer 6 is formed of a solder material such as tin (Sn) or a tin alloy, and has a thickness of about 5 $\mu$m. When a portion of the bonding members 2a and 2b does not include the nanospring layer 4, a difference in thermal deformation between the semiconductor chip 1 and the conductive member 3 is absorbed by the deformation of the bonding layer 6, therefore, it is necessary to ensure a sufficient thickness of the bonding layer 6. On the other hand, in the structure of the first embodiment in which a portion of the bonding members 2a and 2b includes the nanospring layer 4, a difference in thermal deformation between the semiconductor chip 1 and the conductive member 3 can be absorbed by the deformation of the nanospring layer 4. Thus, since it is not necessary to cause the bonding layer 6 to absorb the thermal deformation difference, the thickness of the bonding layer 6 can be sufficiently small.

Moreover, when a portion of the bonding members 2a and 2b does not include the nanospring layer 4, there is a fear of occurrence of voids or an unbonded portion if surface irregularities of the bonding surface are large, therefore, a bonding thickness capable of absorbing the surface irregularities is required. On the other hand, in the structure of the first embodiment in which a portion of the bonding members 2a and 2b includes the nanospring layer 4 and the planar layer 5 thinner than the nanospring layer 4, since the surface irregularities of the bonding surface can be absorbed by the deformation of the nanospring layer 4, the bonding layer 6 can be thinned to a thickness of the order of $\mu$m or less. In the semiconductor device having the structure of the first embodiment as described above, the thickness of the bonding layer 6, although larger than the planar layer 5, can be made smaller than the nanospring layer 4. Based on these facts, the bonding layer 6 is sufficiently thinned to reduce the thermal resistance thereof, so that the bonding layer 6 can contribute to a reduction in the thermal resistance of the entire semiconductor device.

Although, in the first embodiment, nickel is used for the material of the nanospring layer 4 or the planar layer 5, other conductive materials such as copper can also be used. When copper is used for the material of the nanospring layer 4 or the planar layer 5, the thermal conductivity of the bonding members 2a and 2b is further improved, therefore, the thermal resistance of the entire semiconductor device can be further reduced. Moreover, since copper has a smaller modulus of elasticity or yield stress than that of nickel, the deformation absorbing effect of the nanospring layer 4 or the deformation following capability of the planar layer 5 is further improved. On the other hand, since copper is an easily oxidizable material compared to nickel, oxidation prevention treatment may be required. Further, although, in the first embodiment, a metal containing tin as a main component is used for the material of the bonding layer 6, a metal containing zinc (Zn) or silver (Ag) as a main component can also be used. When changing the material of the bonding layer 6, it is necessary to properly adjust conditions such as a bonding temperature or pressurization according to each material.

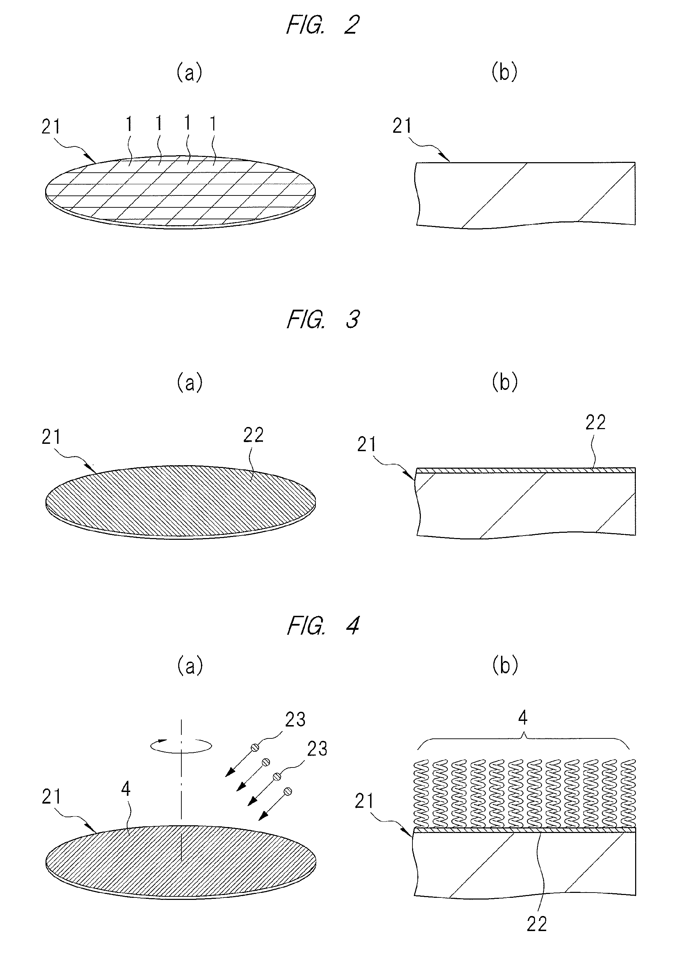

Next, with reference to FIG. 2 to FIG. 9, a method for manufacturing the semiconductor device of the first embodiment will be described. In each of FIG. 2 to FIG. 6, (a) is an overall perspective view of a semiconductor wafer, and (b) is an enlarged cross-sectional view of a surface edge of the semiconductor wafer.

First, as shown in FIG. 2, a semiconductor wafer 21 configured from a plurality of semiconductor chips 1 is prepared. In each of the semiconductor chips 1 of the semiconductor wafer 21, a diode element formed of a p-n junction is formed.

Next, as shown in FIG. 3, the under layer 22 formed of a nickel film is formed on the surface of the semiconductor wafer 21 using a vapor deposition method. The under layer 22 is provided for purposes of improving the bonding strength between the semiconductor chip 1 and the nanospring layer 4, or uniformly transferring electricity or heat to the nanospring layer 4. The under layer 22 can be formed by a plating method instead of a vapor deposition method. Moreover, when a metal layer is provided on the surface of the semiconductor wafer 21 in a semiconductor manufacturing process (front-end process), the metal layer can be used as the under layer 22, therefore, the step of forming the under layer 22 can be omitted.

Next, as shown in FIG. 4, the semiconductor wafer 21 is rotated about an axis vertical to the surface of the under layer 22 under a substantially vacuum environment. Then, in this state, nickel atoms 23 are emitted from an evaporation source (not shown) disposed in the obliquely upward direction, and are vapor deposited on the surface of the under layer 22.

When the nickel atoms 23 are vapor deposited from an oblique direction with respect to the surface of the under layer 22 as described above, a place to be shadowed by the evaporation source is generated in the nickel atom layer that is vapor deposited on the surface of the under layer 22, and the nickel atoms 23 are not vapor deposited at the shadow portion. As a result, numerous columnar bodies extending in an oblique direction are vapor deposited and formed on the surface of the under layer 22. Then, by rotating the semiconductor wafer 21 at this time, the columnar body does not extend in one direction but grows in a coil shape. Due to this, numerous coil-shaped springs of nano-order size that constitute the nanospring layer 4 are formed on the surface of the under layer 22.

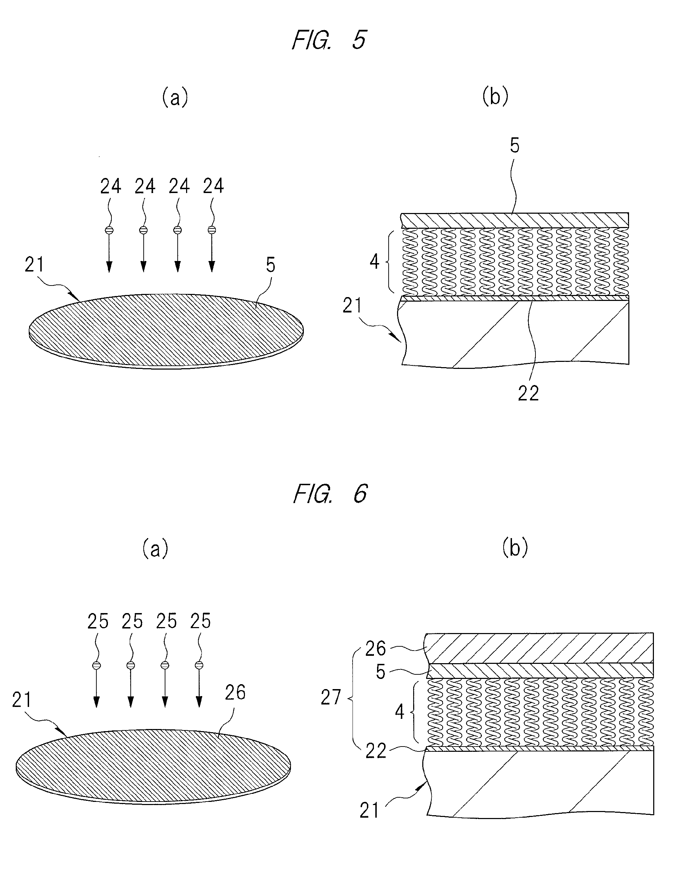

Next, after stopping the rotation of the semiconductor wafer 21, nickel atoms 24 are vapor deposited from above the nanospring layer 4 to thereby form the planar layer 5 on the top of the nanospring layer 4 as shown in FIG. 5. Subsequently, as shown in FIG. 6, tin atoms 25 are vapor deposited from above the planar layer 5, with the rotation of the semiconductor wafer 21 stopped, to thereby form a bonding layer 26 before bonding on the top of the planar layer 5.

Through the steps so far, the under layer 22, the nanospring layer 4, the planar layer 5, and the bonding layer 26 are formed in this order on the surface of the semiconductor wafer 21. Hereinafter, a set of these layers is referred to as a surface forming layer 27.

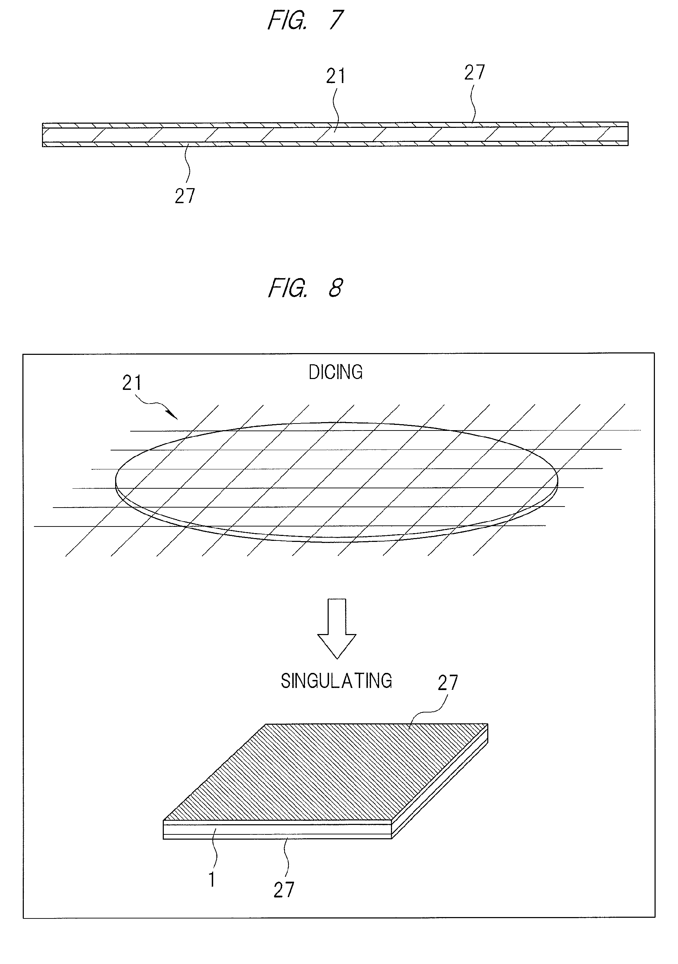

Next, after reversing the surface and back surface of the semiconductor wafer 21, the same procedure as described above is carried out, whereby the surface forming layer 27 is also formed on the back surface of the semiconductor wafer 21 as shown in FIG. 7.

Thereafter, as shown in FIG. 8, by dicing and singulating the semiconductor wafer 21, many semiconductor chips 1 provided with the surface forming layers 27 on the both surfaces are obtained.

In the manufacturing method described above, prior to the step of dicing and singulating the semiconductor wafer 21, the surface forming layer 27 is formed on the both surfaces thereof. However, the surface forming layer 27 may be formed on the both surfaces of the semiconductor chip 1 by the method described above after dicing and singulating the semiconductor wafer 21. In this case, when the nanospring layer 4 is formed by depositing the nickel atoms 23 from an oblique direction, consideration must be given so that the nickel atoms 23 are not vapor deposited on the side surface of the semiconductor chip 1. On the other hand, when the surface forming layer 27 is formed on the both surfaces of the semiconductor wafer 21 prior to dicing and singulation, consideration must be given so that the surface forming layer 27 is not damaged when dicing and singulating the semiconductor wafer 21. Thus, it is desirable to select a proper step according to the dicing method or the like.

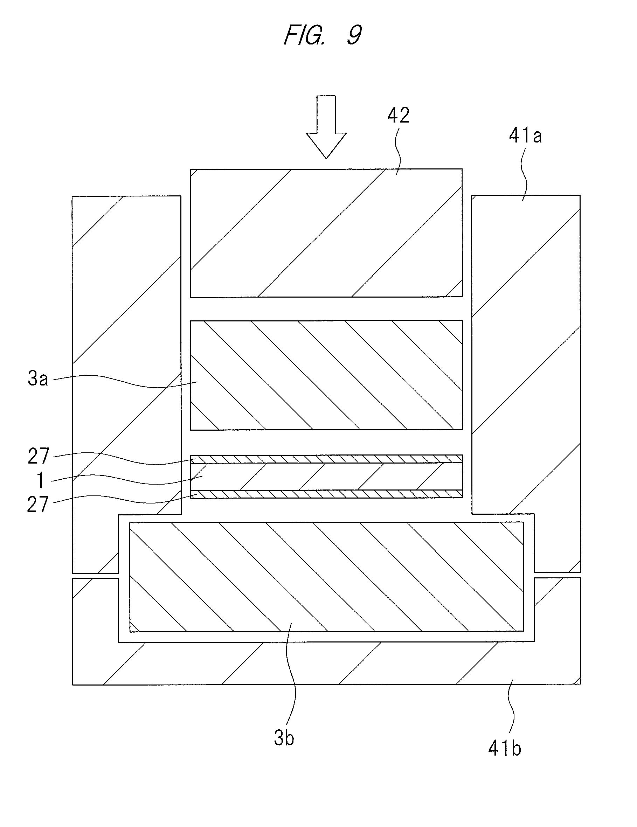

Next, as shown in FIG. 9, the semiconductor chip 1 with the surface forming layers 27 formed on the both surfaces is interposed between the pair of conductive members 3a and 3b, and further, a weight 42 used for pressurization at the time of bonding is disposed on the top of the conductive member 3a. At this time, for preventing misalignment among the members (the semiconductor chip 1 and the conductive members 3a and 3b) before bonding, the members are aligned using bonding jigs 41a and 41b made of carbon.

Since the bonding layer 26 before bonding is formed on the both surfaces of the semiconductor chip 1, it is not necessary to separately stack a bonding material when aligning the members using the bonding jigs 41a and 41b, thereby making it possible to improve assemblability.

Next, the members aligned using the bonding jigs 41a and 41b are exposed to an environment of a melting point or higher of the bonding layer 26 before bonding, and thereafter, the temperature is lowered. At this time, the bonding layer 26 before bonding, which is liquefied, reacts with the atoms constituting the planar layer 5 or the atoms constituting the conductive members 3a and 3b to be alloyed, and becomes the alloyed bonding layer 6 after lowering the temperature. Then, with this bonding layer 6, the planar layer 5 and the conductive member 3a are bonded together, and the planar layer 5 and the conductive member 3b are bonded together. In the first embodiment, the alloyed bonding layer 6 is an alloy of tin and nickel, tin and copper, or tin, nickel, and copper. This bonding step is carried out using a reflow furnace under a substantially vacuum environment. Due to this, it is possible to reduce an unbonded portion or voids occurring at the time of bonding. Finally, the bonding jigs 41a and 41b and the weight 42, which are cooled down, are removed, whereby the semiconductor device of the first embodiment shown in FIG. 1 is completed.

According to the manufacturing method described above, since the nanospring layer 4 in which springs having dimensions of nano-order size, that is, less than 1 $\mu$m are densely disposed can be manufactured, it is possible to realize a semiconductor packaging structure having remarkable differences in structure and effect from the related art.

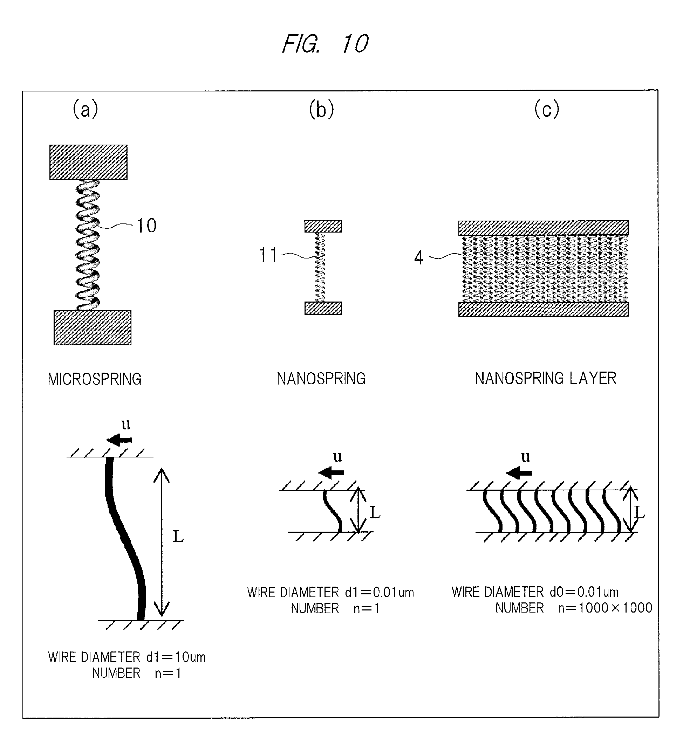

Next, features obtained when using the nanospring layer 4 manufactured by the manufacturing method in a semiconductor packaging structure will be described using FIG. 10. FIG. 10(a) shows a microspring 10 having dimensions of micro-order size as a related art, FIG. 10(b) shows a nanospring 11 obtained by simply scaling down the microspring 10 shown in FIG. 10(a) to a nano-order size, and FIG. 10(c) shows the nanospring layer 4 of the first embodiment in which the nanosprings 11 are densely disposed.

A difference in thermal deformation between the semiconductor chip 1 and the conductive member 3 is mainly absorbed by shear deformation of the nanospring layer 4. Therefore, each of the springs is regarded as one needle to which the shear deformation is applied, and the microspring 10, the nanospring 11, and the nanospring layer 4 are modeled as one needle having a wire diameter of 10 $\mu$m, one needle having a wire diameter of 10 nm, and 1000000 (= 1000 x 1000) needles having a wire diameter of 10 nm, respectively. The height of the needles and the thickness of the nanospring layer 4 are all set to the same value L.

In this case, a maximum stress ($\sigma_{max}$) occurring in the needle is expressed by the following formula.

[Formula 1]

$$\sigma_{\max} = \frac{3}{4}\frac{Edu}{L^2}$$

(wherein, E is the modulus of longitudinal elasticity, d is the wire diameter, and u is the shear displacement to be applied.)

Based on the formula, the stresses occurring in the nanospring layer 4 and the spring 11 of nano-order size are the same, while a stress 1000 times that of the nanospring layer 4 and the spring 11 occurs in the spring 10 of micro-order size where d is 1000 times that of the nanospring layer 4 and the spring 11, so that the prevention of breakage of the spring is a problem.

On the other hand, a thermal resistance (R) is expressed by the following formula.

[Formula 2]

$$R = \frac{4L}{\lambda \pi d^2 n}$$

(wherein, $\lambda$ is the thermal conductivity of a material, and n is the number)

Based on the formula, the thermal resistances of the nanospring layer 4 and the spring 10 of micro-order size are the same, while the thermal resistance is 1000000 times that of the nanospring layer 4 and the spring 10 in the spring 11 of nano-order size, which makes the temperature rise of the semiconductor chip 1 remarkable. In order to make the stress occurring in the spring 10 of micro-order size the same as the nanospring layer 4, the height L needs to be increased by 32 times, and in this case, the thermal resistance is increased by 32 times.

Based on these facts, it is understood that a function of achieving both deformation absorption and a low thermal resistance that are required of a semiconductor packaging structure is a function that cannot be realized by the spring 10 of micro-order size as a related art or the spring 11 of nano-order size obtained by simply scaling down the spring 10, but can be first realized by the nanospring layer 4 of the first embodiment.

In the first embodiment, the packaging structure of the semiconductor chip 1 having diode characteristics has been described. However, it is of course possible to package a semiconductor chip including other semiconductor elements, in which case the design of the packaging structure of the first embodiment may be appropriately changed according to conditions of each semiconductor chip.

(Second Embodiment)

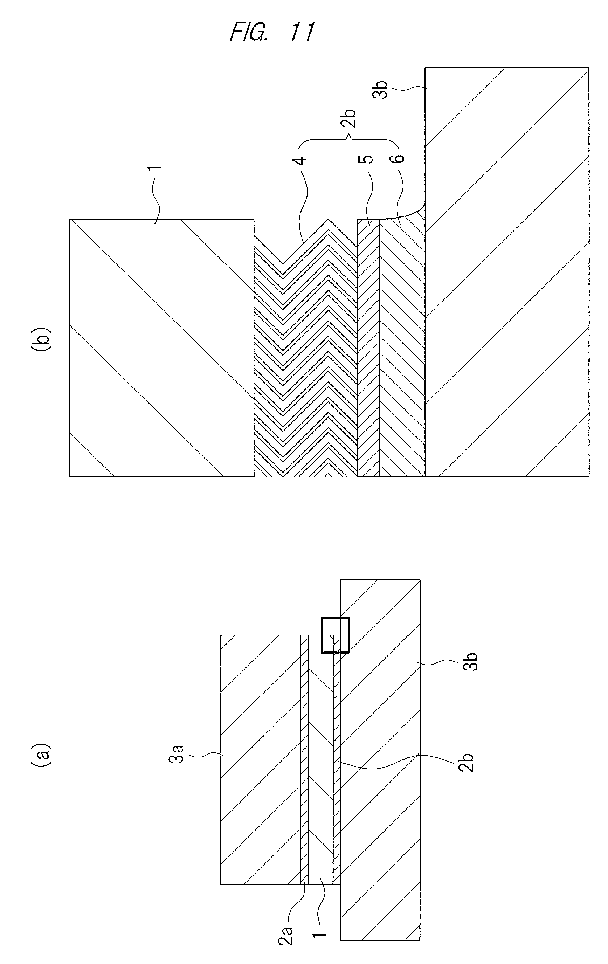

FIG. 11(a) is a cross-sectional view of a semiconductor device according to a second embodiment of the present invention, and FIG. 11 (b) is an enlarged cross-sectional view showing a portion of FIG. 11(a).

A difference from the first embodiment is that springs constituting the nanospring layer 4 are not coil-shaped springs but are zigzag-shaped springs.

Since the nanospring layer 4 is configured from zigzag-shaped springs, the occupied area per spring is reduced compared to coil-shaped springs, so that more springs can be disposed in a unit area. Moreover, the length of each spring when being straightened can be shortened.

Based on these facts, the thermal resistance of the nanospring layer 4 can be further reduced, but the efficiency of thermal deformation absorption may be lower than that of the coil-shaped spring. Thus, the shape of the spring may be selected in view of these features.

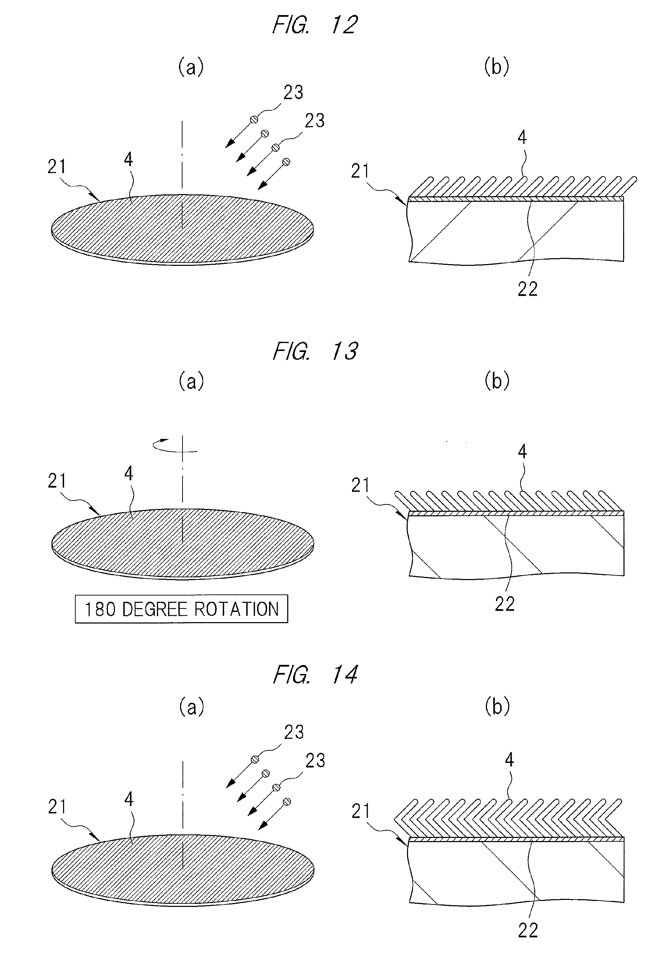

Next, a method for manufacturing the semiconductor device of a second embodiment will be described with reference to FIG. 12 to FIG. 14. Since a difference from the first embodiment lies only in the manufacturing method of the nanospring layer 4, the manufacturing method of the nanospring layer 4 will be described herein. In each of FIG. 12 to FIG. 14, (a) is an overall perspective view of a semiconductor wafer, and (b) is an enlarged view of a surface edge of the semiconductor wafer.

First, the under layer 22 is formed on the surface of the semiconductor wafer 21 by the same method as the first embodiment, and thereafter, as shown in Fig. 12, the nickel atoms 23 are emitted from the obliquely upward direction of the semiconductor wafer 21 under a substantially vacuum environment, and are vapor deposited on the surface of the under layer 22. At this time, unlike the manufacturing method of the first embodiment, the semiconductor wafer 21 is not rotated.

As described above, when the nickel atoms 23 are vapor deposited from an oblique direction with respect to the surface of the under layer 22, a place to be shadowed by the evaporation source is generated in the nickel atom layer that is vapor deposited on the surface of the under layer 22, and the nickel atoms 23 are not vapor deposited at the shadow portion. As a result, numerous columnar bodies extending in an oblique direction are vapor deposited and formed on the surface of the under layer 22.

Next, as shown in FIG. 13, the semiconductor wafer 21 is rotated by 180 degrees about an axis vertical to the surface of the under layer 22. Due to this, the direction of the numerous columnar bodies that are vapor deposited and formed on the surface of the under layer 22 is opposite to the direction shown in FIG. 12.

Next, as shown in FIG. 14, when the nickel atoms 23 are emitted in this state from the obliquely upward direction of the semiconductor wafer 21, the numerous columnar bodies grow in a "dogleg" shape. Subsequently, by repeating the steps so far the desired number of times, the nanospring layer 4 configured from numerous zigzag-shaped springs shown in Fig. 11 is formed.

(Third Embodiment)

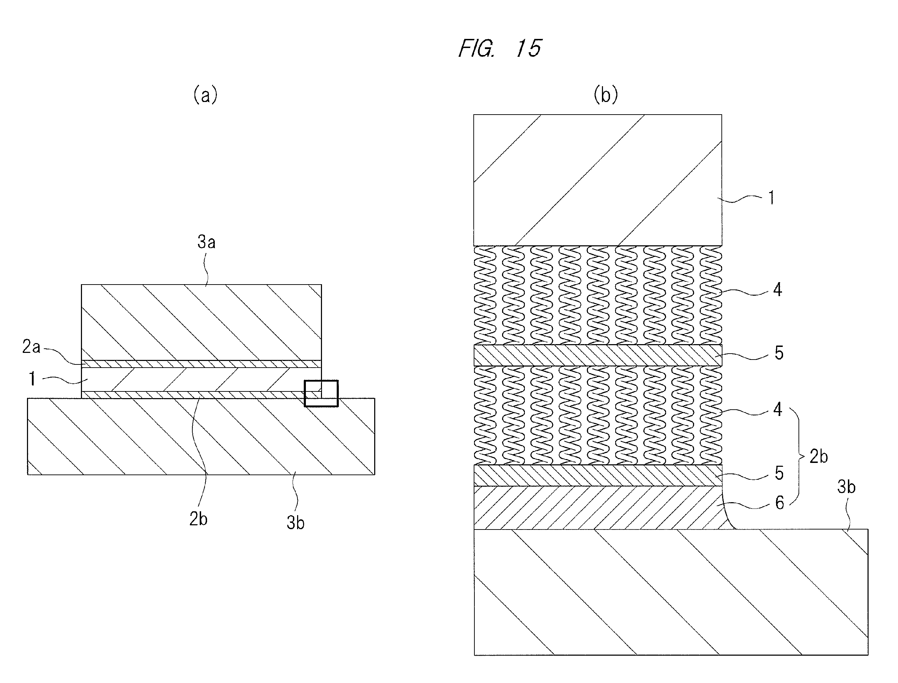

FIG. 15(a) is a cross-sectional view of a semiconductor device according to a third embodiment of the present invention, and FIG. 15(b) is an enlarged cross-sectional view showing a portion of FIG. 15(a).

A difference from the first embodiment is that the nanospring layers 4 are stacked in multiple stages via the planar layer 5. FIG. 15 shows an example in which two stages of the nanospring layers 4 are stacked. However, by alternately repeating the formation of the nanospring layer 4 and the formation of the planar layer 5, three or more stages of the nanospring layers 4 can be stacked. Moreover, the springs constituting the nanospring layer 4 are not limited to the coil-shaped springs, and may be the zigzag-shaped springs as in the second embodiment.

In general, when the nanospring layers 4 of the third embodiment are stacked in n stages, the amount of deformation to be absorbed by each of the nanospring layers 4 is reduced to $1/n$, therefore, greater deformation can be absorbed. On the other hand, the thermal resistance or electrical resistance of the entire nanospring layers 4 is increased by n times. Thus, it is desirable to select the number of nanospring layers 4 to be stacked according to required deformation absorbing ability, thermal resistance, and electrical resistance.

(Fourth Embodiment)

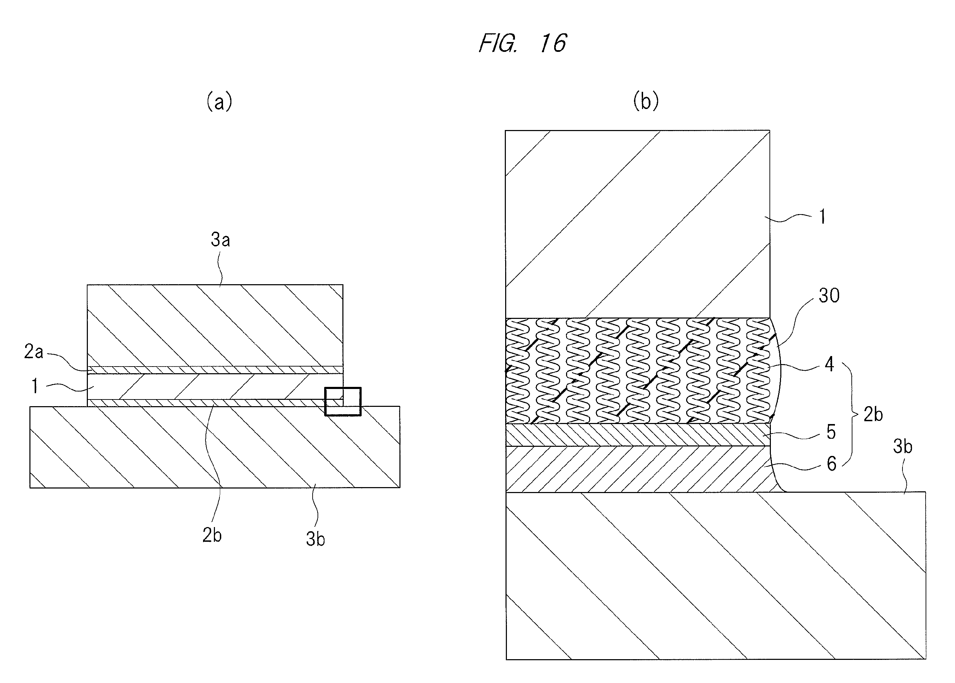

FIG. 16(a) is a cross-sectional view of a semiconductor device according to a fourth embodiment of the present invention, and FIG. 16(b) is an enlarged cross-sectional view of a portion of FIG. 16(a).

A difference from the first embodiment is that gaps of a plurality of springs constituting the nanospring layer 4 are filled with a resin 30. In such a case, the average stiffness of the entire nanospring layer 4 can be controlled according to the physical properties of the resin 30 for filling.

For example, when the gaps are filled with a resin having a small modulus of elasticity, the average stiffness of the entire nanospring layer 4 is reduced, and a thermal stress occurring in the semiconductor chip 1 or the conductive members 3a and 3b can be reduced. On the other hand, when the gaps are filled with a resin having a large modulus of elasticity, the average stiffness of the entire nanospring layer 4 is increased, and a thermal deformation difference to be absorbed by the nanospring layer 4 is reduced. Therefore, the thermal resistance can be reduced by further thinning the nanospring layer 4. Thus, the material of the resin 30 for filling may be selected in view of these effects.

The filling of the resin 30 is performed after bonding the semiconductor chip 1 with the conductive member 3. By doing this, an effect of absorbing surface irregularities due to the nanospring layer 4 at the time of bonding is not prevented by the resin 30. Moreover, the resin 30 may fill the entire gaps of the plurality of springs or may fill a portion of the gaps of the plurality of springs.

The invention made by the present inventors has been specifically described so far based on the embodiments. However, the invention is not limited to the embodiments, and it is needless to say that various modifications are possible within a range not departing from the gist of the invention.

### INDUSTRIAL APPLICABILITY

The invention can be applied to a semiconductor device having a packaging structure in which a semiconductor chip is electrically connected to a conductive member via a bonding member.

### Claims

1. A semiconductor device comprising:

   a semiconductor chip; and
   a conductive member electrically connected to the semiconductor chip via a bonding member, wherein the bonding member includes, in order from a side close to the semiconductor chip, a nanospring layer configured from a plurality of springs having a nano-order size, a planar layer supporting the plurality of springs, and a bonding layer,
   a thickness of the nanospring layer is larger than a thickness of the bonding layer, and
   a thickness of the bonding layer is larger than a thickness of the planar layer.

2. The semiconductor device according to claim 1, wherein a material constituting the spring is nickel.

3. The semiconductor device according to claim 1, wherein a material constituting the spring is copper.

4. The semiconductor device according to claim 1, wherein a material constituting the planar layer is nickel.

5. The semiconductor device according to claim 1, wherein a material constituting the planar layer is copper.

6. The semiconductor device according to claim 1, wherein a material constituting the bonding layer is a metal containing tin as a main component.

7. The semiconductor device according to claim 1, wherein the spring has a coil shape.

8. The semiconductor device according to claim 1, wherein the spring has a zigzag shape.

9. The semiconductor device according to claim 1, wherein at least a portion of the nanospring layer is filled with a resin.

10. A semiconductor device comprising:

    a semiconductor chip; and
    a bonding member,
    wherein the bonding member includes, in order from a side close to the semiconductor chip, a nanospring layer configured from a plurality of springs having a nano-order size and a planar layer supporting the plurality of springs, and a thickness of the nanospring layer is larger than a thickness of the planar layer.

11. A method for manufacturing a semiconductor device including a semiconductor chip, and a conductive member electrically connected to the semiconductor chip via a bonding member, in which the bonding member includes, in order from a side close to the semiconductor chip, a nanospring layer configured from a plurality of springs having a nano-order size, a planar layer supporting the plurality of springs, and a bonding layer, the method comprising:

    (a) a step of emitting first atoms from an oblique direction on a surface of a semiconductor wafer to thereby form the nanospring layer;
    (b) a step of emitting, after the step (a), second atoms from a vertical direction on the surface of the semiconductor wafer to thereby form the planar layer;
    (c) a step of emitting, after the step (b), third atoms from the vertical direction on the surface of the semiconductor wafer to thereby form the bonding layer; and
    (d) a step of dicing, after the step (c), the semiconductor wafer to singulate the semiconductor wafer into a plurality of the semiconductor chips,

    wherein a thickness of the nanospring layer is made larger than a thickness of the bonding layer, and a thickness of the bonding layer is made larger than a thickness of the planar layer.

12. The method for manufacturing the semiconductor device according to claim 11,

wherein, in the step (a), the spring constituting the nanospring layer is formed in a coil shape by rotating the semiconductor wafer about an axis vertical to the surface thereof.

**13.** The method for manufacturing the semiconductor device according to claim 11, wherein, in the step (a), the spring constituting the nanospring layer is formed in a zigzag shape by alternately repeating a step of emitting the first atoms from the oblique direction on the surface of the semiconductor wafer and a step of rotating the semiconductor wafer by 180 degrees about an axis vertical to the surface thereof.

*FIG. 1*

(a)

(b)

## FIG. 2

(a)

(b)

## FIG. 3

(a)

(b)

## FIG. 4

(a)

(b)

*FIG. 5*

(a)

(b)

*FIG. 6*

(a)

(b)

*FIG. 7*

*FIG. 8*

FIG. 9

## FIG. 10

(a)

10

MICROSPRING

u

L

WIRE DIAMETER d1＝10um
NUMBER n＝1

(b)

11

NANOSPRING

u

L

WIRE DIAMETER d1＝0.01um
NUMBER n＝1

(c)

4

NANOSPRING LAYER

u

L

WIRE DIAMETER d0＝0.01um
NUMBER n＝1000×1000

FIG. 11

(a)

(b)

## FIG. 12

(a)

(b)

## FIG. 13

(a)

(b)

180 DEGREE ROTATION

## FIG. 14

(a)

(b)

EP 2 945 189 A1

*FIG. 15*

(a)

(b)

EP 2 945 189 A1

FIG. 16

(a)

(b)

## INTERNATIONAL SEARCH REPORT

| International application No. |
| --- |
| PCT/JP2013/050196 |

A. CLASSIFICATION OF SUBJECT MATTER
*H01L21/52*(2006.01)i, *H01L21/60*(2006.01)i

According to International Patent Classification (IPC) or to both national classification and IPC

B. FIELDS SEARCHED

Minimum documentation searched (classification system followed by classification symbols)
H01L21/52, H01L21/60

Documentation searched other than minimum documentation to the extent that such documents are included in the fields searched
| Jitsuyo Shinan Koho | 1922-1996 | Jitsuyo Shinan Toroku Koho | 1996-2013 |
| Kokai Jitsuyo Shinan Koho | 1971-2013 | Toroku Jitsuyo Shinan Koho | 1994-2013 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X Y | JP 2007-531243 A (Gelcore L.L.C.), 01 November 2007 (01.11.2007), paragraphs [0006] to [0042]; fig. 1 & US 2005/0006754 A1 & EP 1642333 A & WO 2005/031860 A2 | 1-6,10-13 7-9 |
| Y | JP 2007-165383 A (Ibiden Co., Ltd.), 28 June 2007 (28.06.2007), paragraphs [0036] to [0037]; fig. 3 & US 2007/0190819 A1 & US 2009/0053910 A1 & US 2009/0053911 A1 & EP 1959717 A1 & WO 2007/066564 A1 & KR 10-2007-0100385 A & CN 101147435 A | 7-8 |

☒ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search 08 April, 2013 (08.04.13) | Date of mailing of the international search report 16 April, 2013 (16.04.13) |
| --- | --- |
| Name and mailing address of the ISA/ Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2013/050196

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2009-253073 A (Fujitsu Ltd.), 29 October 2009 (29.10.2009), paragraph [0076] (Family: none) | 9 |
| A | JP 2010-189690 A (Toshiba Corp.), 02 September 2010 (02.09.2010), entire text; all drawings (Family: none) | 11-13 |

Form PCT/ISA/210 (continuation of second sheet) (July 2009)

## REFERENCES CITED IN THE DESCRIPTION

**Patent documents cited in the description**

- JP 2006287091 A
- JP 2003188209 A
- JP 2003298012 A

**Non-patent literature cited in the description**

- **TAKAYUKI KITAMURA.** FRACTURE NANOMECHANICS. *PAN STANFORD PUBLISHING,* 2011, ISBN 978-981-4241-83-0